**Europäisches Patentamt**

**European Patent Office**

**Office européen des brevets**

(19)

(11) Publication number: **0 039 593**
**B1**

# EUROPEAN PATENT SPECIFICATION

(12)

(45) Date of publication of patent specification: **16.09.87**

(21) Application number: **81301929.6**

(22) Date of filing: **01.05.81**

(51) Int. Cl.⁴: **C 30 B 1/02,** C 30 B 29/26,
H 01 F 1/00

(54) **A method of producing a single crystal of ferrite.**

(30) Priority: **02.05.80 JP 59167/80**

(43) Date of publication of application:
**11.11.81 Bulletin 81/45**

(45) Publication of the grant of the patent:
**16.09.87 Bulletin 87/38**

(84) Designated Contracting States:
**DE FR GB NL**

(56) References cited:
**FR-A-2 457 913**
**US-A-3 332 796**
**US-A-3 414 372**

**ZEITSCHRIFT FÜR ANGEWANDTE PHYSIK, vol.
17, 1964, M. PAULUS: "Magnetische
Untersuchungen aus dem "Laboratoire de
Magnétisme et de Physique du Solide",
C.N.R.S. Bellevue", (S.&O.) Frankreich", pages
216-228**

The file contains technical information
submitted after the application was filed and
not included in this specification

(73) Proprietor: **NGK INSULATORS, LTD.**
**2-56, Suda-cho, Mizuho-ku**
**Nagoya-shi, Aichi 467 (JP)**

(72) Inventor: **Matsuzawa, Soichiro**
**1000-13, Aza-Shinden**
**Ohaza-Rengeji Kuwana City (JP)**
Inventor: **Mase, Syunzo**
**435, Aza-Motokinogo Ohaza-Tobishima-shinden**
**Tobishima-Mura Ama-Gun Aichi Pref. (JP)**

(74) Representative: **Paget, Hugh Charles Edward
et al
MEWBURN ELLIS & CO. 2/3 Cursitor Street
London EC4A 1BQ (GB)**

## Description

The present invention relates to a method of producing a single crystal of ferrite, more particularly by bringing a polycrystal of ferrite and a single crystal of ferrite into contact and firing the contacted crystals to grow the single crystal of ferrite through a solid phase reaction.

There is known the Bridgman process for producing a single crystal of ferrite, wherein a starting material is melted at a temperature higher than the melting point of the starting material and a single crystal is grown from the molten liquid phase. However, the Bridgman process requires a temperature higher than 1,600°C, so that in the case of production of a single crystal of ferrite using a starting material having a high vapor pressure, such as zinc oxide, the composition readily varies and impurities are readily admixed from a crucible used for melting the starting material, so that the crystallinity of the obtained single crystal is not uniform. Furthermore, the Bridgman process requires large size expensive and complicated production apparatus and it is difficult to control the heating condition upon production and the condition for forming a nucleus of a single crystal, so that mass production is difficult and therefore it becomes expensive to obtain a single crystal product.

The present invention aims to overcome these prior defects and problems and provides a method of producing a larger single crystal of ferrite wherein a single crystal of ferrite which is a seed (nucleus) is contacted with a polycrystal of ferrite and the contacted crystals are fired to effect a solid phase reaction whereby a single crystal of ferrite is grown.

More particularly, the present invention provides a method of producing a single crystal of ferrite wherein a polycrystal of ferrite and a single crystal of ferrite are heated in contact with each other to grow the single crystal of ferrite toward the polycrystal of ferrite, wherein the polycrystal of ferrite is produced by using iron oxide containing iron oxide of spinel structure and/or iron oxide having hysteresis of spinel structure in an amount of not less than 60% by weight calculated as $Fe_2O_3$, and wherein the heating is effected at a temperature lower than the temperature at which discontinuous grain growth of the polycrystal of ferrite is caused.

The present invention is based on the discovery attained after a large number of studies that when a particularly defined polycrystal of ferrite, that is a polycrystal of ferrite having a high density and exhibiting a discontinuous grain growth, which has been prepared by using for the iron oxide starting material, which is the main component of ferrite, iron oxide containing iron oxide of spinel structure, that is magnetite ($Fe_3O_4$) or maghemite ($\gamma$-$Fe_2O_3$), or iron oxide having hysteresis of the above described spinel structure, that is hematite ($\alpha$-$Fe_2O_3$) produced from the above described magnetite or maghemite, or a mixture thereof in an amount of not less than 60% by weight

calculated as $Fe_2O_3$, is contacted with a single crystal of ferrite and the contacted ferrites are heated at a particularly defined temperature, that is a temperature lower than the temperature at which discontinuous grain growth of the polycrystal of ferrite is caused, the single crystal of ferrite is grown to obtain a larger single crystal of ferrite.

In the following description of the present invention, reference will be made to the accompanying drawings, in which:

Figure 1 is a graph showing the relation of the firing temperature to the average grain size of a polycrystal of ferrite; and

Figure 2 is a graph showing the relation of the firing maintaining time to the average grain size of a polycrystal of ferrite.

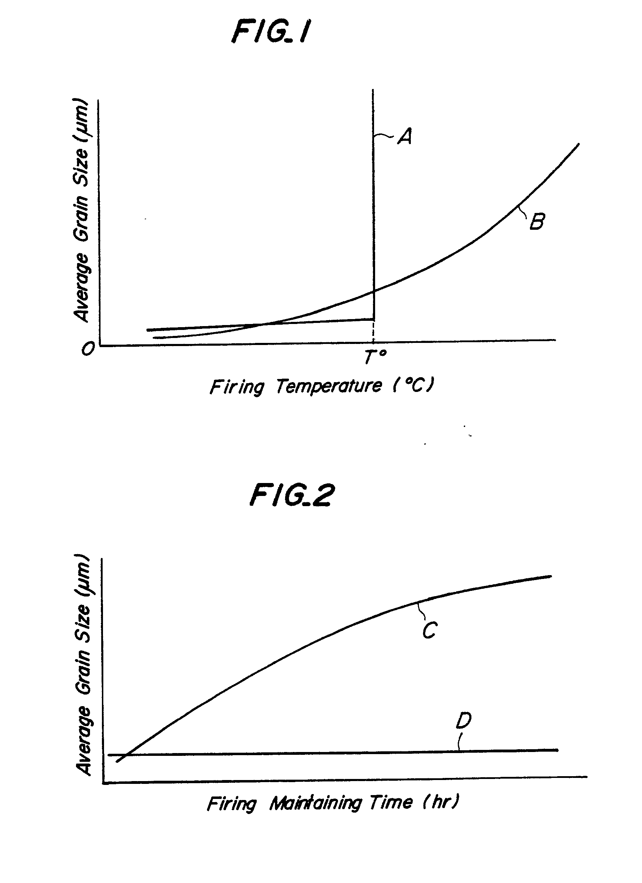

It is known that polycrystals of ferrite wherein microcrystals assemble include polycrystals of ferrite exhibiting a discontinuous grain growth as shown in Figure 1, curve A, in which when the firing temperature reaches a particularly defined temperature T°C, a part of the crystal grains suddenly integrates the surrounding microcrystal grains and grows to a macrocrystal grain at a far higher grain growing speed than the growing speed of the surrounding microcrystal grains, and polycrystals of ferrite exhibiting a continuous grain growth as shown in Figure 1, curve B, in which crystal grains grow continuously with raising of temperature.

In the present invention, among these polycrystals, a polycrystal of ferrite exhibiting discontinuous grain growth at a particularly defined temperature T°C as shown in the curve A is used, and as the iron oxide starting material, which is the main component of ferrite polycrystals, iron oxide containing iron oxide of spinel structure, iron oxide having hysteresis of spinel structure or a mixture thereof in an amount of not less than 60% by weight calculated as $Fe_2O_3$ is used, and the starting material powder for ferrite mixed with the other starting materials is shaped and fired to prepare the particularly defined polycrystal of ferrite which is used in the present invention.

Preferably, each contacting surface of the polycrystal of ferrite and the single crystal of ferrite is polished, for example on a tin disc by means of diamond abrasive grains, preferably to a roughness Rmax of less than 0.2 μm, more preferably less than 0.1 μm), both the polished surfaces are contacted directly or in the presence of a solution of an organic or inorganic acid salt containing a metal element constituting the ferrite and/or an acid solution capable of dissolving partially the ferrite, and both the contacted crystals are heated at a temperature which is lower than the temperature causing discontinuous grain growth of the polycrystal of ferrite, that is a temperature lower than T°C in Figure 1 and as near T°C as possible, whereby a solid phase reaction is caused at the interface between the microcrystal grains constituting the polycrystal of ferrite and the single crystal of ferrite and the microcrystal grains in the polycrystal of ferrite are integrated to the single crystal of ferrite and the single crystal of ferrite is gradually grown to form a larger single crystal of ferrite.

Thus, it is particularly important in the present invention that, as mentioned above, as the polycrystal of ferrite use is made of a polycrystal of ferrite exhibiting discontinuous grain growth as shown in Figure 1, curve A, which has been prepared by using iron oxide containing iron oxide of spinel structure, iron oxide having hysteresis of spinel structure or a mixture thereof in an amount of not less than 60% by weight as calculated as $Fe_2O_3$ for the starting material of iron oxide and that the firing is effected at a temperature lower than T°C shown in Figure 1, that is at a temperature lower than the temperature at which discontinuous grain growth of the polycrystal of ferrite occurs, to grow the single crystal.

Magnetite (($FeO)x(Fe_2O_3)y$) and maghemite ($\gamma$-$Fe_2O_3$) are iron oxides of spinel structure and hematite ($\alpha$-$Fe_2O_3$) prepared from the above described magnetite and maghemite is iron oxide having hysteresis of spinel structure.

In order to grow the single crystal of ferrite toward the polycrystal of ferrite by contacting the polycrystal of ferrite with the single crystal of ferrite and heating the contacted ferrites, it is important that the grain size of the polycrystal of ferrite to contact the single crystal of ferrite is fine. This is because at the interface between the single crystal of ferrite and the polycrystal of ferrite, the smaller the diameter of the microcrystal grains of the polycrystal of ferrite, the smaller is the radius of curvature of the interface, so that the transfer speed of the grain boundary is larger and the curvature of the interface is always negative at the single crystal side, so that the single crystal of ferrite can be grown toward the polycrystal of ferrite. In this case, when the crystal grains of the polycrystal of ferrite exceed 40 μm, transfer of the boundary is substantially difficult, so that the crystal grains of the polycrystal of ferrite are preferably less than 40 μm. The grain size of a polycrystal of ferrite exhibiting discontinuous grain growth as shown in Figure 1, curve A, does not substantially vary and the fine state is maintained until the temperature reaches the particularly defined temperature T°C even if the temperature is raised within the temperature range reaching the particularly defined temperature T°C; as shown in Figure 2, curve D, even if the firing maintaining temperature is prolonged, the grain size does not substantially vary. On the contrary, a polycrystal of ferrite exhibiting continuous grain growth undergoes grain growth with raising of the temperature and lapse of the firing maintaining time as shown in Figure 1, curve B, and Figure 2, curve C.

Accordingly, in the present invention there is used a polycrystal of ferrite exhibiting discontinuous grain growth in which the crystal grains are not substantially grown up to the particularly defined temperature T°C and wherein a fine grain size is maintained.

As mentioned above, as the polycrystal of ferrite exhibiting discontinuous grain growth, there is used a polycrystal of ferrite prepared by using iron oxide containing iron oxide of spinel structure, iron oxide having hysteresis of spinel structure of a mixture thereof in an amount of not less than 60% by weight calculated as $Fe_2O_3$, for the starting material of iron oxide in the production of the polycrystal of ferrite. This is because, when a polycrystal of ferrite prepared by using any other iron oxide is used, if this polycrystal of ferrite is contacted with the single crystal of ferrite and the contacted ferrites are heated to such a temperature that the single crystal of ferrite is grown, grain growth occurs relatively rapidly and suddenly concurrently in the inner portion of the polycrystal of ferrite and the greatly grown grain inhibits the growth of the single crystal of ferrite and a single crystal of ferrite having a practically usable size cannot be obtained. Furthermore, even if iron oxide having no hysteresis of spinel structure is contained in the iron oxide starting material, a single crystal of ferrite can be produced, but the above described iron oxide content must be not more than 40%. If the content exceeds 40%, the obtained polycrystal of ferrite exhibits continuous grain growth, so that it is substantially impossible to grow the single crystal of ferrite as mentioned above. Furthermore, even if the content is not more than 40%, as the content increases, the firing temperature when producing the single crystal of ferrite must be raised and the production conditions become severe, so that the content is preferably smaller, more preferably less than 20%.

The iron oxide starting material is preferably one having a high purity and a low content of impurities, such as $SiO_2$, an alkali metal oxide, an alkaline earth metal oxide, $TiO_2$, $Nb_2O_5$, MgO, or $Al_2O_3$, and in particular the contents of $SiO_2$ and CaO are preferably less than 0.02% respectively. When the content of the impurities as described above is high, the porosity of the obtained polycrystal of ferrite is considerably increased and in the heating step in the production of the single crystal of ferrite discontinuous grain growth occurs locally at the inner portion of the polycrystal of ferrite at a temperature lower than the temperature at which the single crystal of ferrite is grown and a homogeneous single crystal of ferrite may not be produced. It is preferable that the starting materials constituting ferrite, such as manganese oxide, nickel oxide and zinc oxide, have high purity.

Iron oxide of spinel structure or iron oxide having hysteresis of spinel structure may be produced as follows. For example, a suspension of ferrous hydroxide prepared by adding an alkali to an aqueous solution of ferrous sulfate is oxidized by feeding air or oxygen while controlling the pH value to be about 7 and the temperature to be about 80°C to prepare magnetite ($Fe_3O_4$). Magnetite is then oxidized to prepare maghemite ($\gamma$-$Fe_2O_3$) and hematite ($\alpha$-$Fe_2O_3$). Alternatively, a suspension of ferrous hydroxide prepared by adding an alkali to ferrous sulfate is controlled at a pH of about 4 and a temperature of about 60°C and air is fed thereto to prepare geothite ($\alpha$-FeOOH), which is heated in a hydrogen atmosphere and hydrogenated to prepare magnetite ($Fe_3O_4$). The obtained magnetite is oxidized to obtain maghemite ($\gamma$-$Fe_2O_3$) and hematite ($\alpha$-$Fe_2O_3$). In a further alternative procedure, ferrous oxalate prepared by adding oxalic acid to a solution of ferrous chloride is coated in a non-oxidizing atmosphere to prepare magnetite ($Fe_3O_4$). The thus formed magnetite is oxidized to prepare maghemite ($\gamma$-$Fe_2O_3$) and hematite ($\alpha$-$Fe_2O_3$).

The firing process for producing the polycrystal of ferrite may be a conventional firing method, hot press method or hot isotactic press method. It is more preferable that the above described solution exists between the contacting surfaces of the polycrystal of ferrite and the single crystal of ferrite and this is effective for improving the activity of the interface between the microcrystal grains constituting the polycrystal of ferrite and the single crystal of ferrite and promoting the occurrence of the solid phase reaction.

The temperature at which discontinuous grain growth occurs in the polycrystal of ferrite utilized in the method of the present invention varies depending upon the kind of the iron oxide starting material to be used in the production of the polycrystal of ferrite, and the condition for producing the polycrystal of ferrite, and the temperature at which discontinuous grain growth is caused is confirmed by previously carrying out a heating test.

By the term "temperature lower than the temperature at which discontinuous grain growth occurs", which is the heating temperature for bonding the polycrystal of ferrite and the single crystal of ferrite, there is meant a temperature lower than the temperature at which a part of microcrystal grains suddenly grow into macrocrystal as shown in Figure 1, T°C, and is preferably a temperature within 100°C lower than T°C, and this temperature is confirmed by previously carrying out a heating test.

The invention will be further described with reference to the following illustrative Examples.

Example 1

Iron oxide which is magnetite ($Fe_3O_4$) having a purity of 99.9% and containing 0.005% of $SiO_2$, 0.005% of $TiO_2$, 0.005% of CaO and 0.01% of $Na_2O$ as impurities, which had been prepared by feeding oxygen to a suspension of ferrous hydroxide prepared by adding aqueous ammonia to an aqueous solution of purified ferrous sulfate while maintaining the pH value at 7 and the temperature at about 80°C, manganese oxide and zinc oxide, each having a purity of 99.9%, were compounded to obtain a composition comprising 31 mol% of MnO, 16.5 mol% of ZnO and 52.5 mol% of $Fe_2O_3$. The resulting mixture was calcined, milled and then shaped and heated at 1,320°C for 4 hours under equilibrium oxygen partial pressure to obtain a manganese zinc ferrite polycrystal.

This polycrystal of ferrite had an average grain size of about 10 μm and a porosity of about 0.1% and the temperature at which discontinuous grain growth occurred was 1,360°C. From this polycrystal of ferrite and a single crystal of ferrite having substantially the same composition as the ferrite polycrystal and produced by a high pressure Bridgman process, plates 15×15×5 mm and 15×15×0.5 mm respectively were cut off and each contacting surface of these plates was polished with a tin disc by means of diamond abrasive grains to a roughness Rmax of 0.05 μ. 6N $HNO_3$ solution was applied onto the polished contacting surfaces and the polycrystal of ferrite plate and the single crystal of ferrite plate were superposed and heated at 1,150°C for 30 minutes under a nitrogen atmosphere and then maintained for 3 hours at a temperature of 1,350°C, which is lower than the above described temperature of 1,360°C at which discontinuous grain growth of the polycrystal of ferrite occurs, to cause a solid phase reaction. Thus, the orginally superposed polycrystal of ferrite was entirely formed into a single crystal to obtain an integral single crystal of ferrite having a thickness of 5.5 mm. Another superposed ferrite plate was kept at 1,320°C for 1 hour to obtain a polycrystal-single crystal of ferrite having a composite structure in which the originally superposed polycrystal of ferrite was formed into the single crystal to an extent of 0.5 mm from the contacting surface of the single crystal of ferrite.

For comparison, when there was used a polycrystal of ferrite using hematite ($\alpha$-$Fe_2O_3$) having no hysteresis of spinel structure, which was obtained by directly roasting ferrous sulfate in air, no discontinuous grain growth was observed in the polycrystal of ferrite and the continuous grain growth was confirmed. When this polycrystal of ferrite was contacted with a single crystal of ferrite in the same manner as described above and heated at 1,400°C for 4 hours, the single crystal of ferrite grew only about 0.1 mm and no single crystal of ferrite of commercially usable size was obtained.

Example 2

Iron oxide which is magnetite ($Fe_3O_4$) and containing 0.005% of $SiO_2$, 0.005% of $TiO_2$, 0.005% of CaO and 0.005% of $Na_2O$ as impurities, which has been prepared by roasting ferrous oxalate prepared by adding a solution of oxalic acid to an aqueous solution of purified ferrous chloride in nitrogen gas, manganese oxide and zinc oxide, each having a purity of 99.9%, were compounded to obtain a composition comprising 28 mol% of MnO, 19.5 mol% of ZnO and 52.5 mol% of $Fe_2O_3$. The resulting mixture was calcined, milled and then shaped and heated at 1,320°C for 4 hours under equilibrium oxygen partial pressure to obtain a manganese zinc ferrite polycrystal.

This polycrystal of ferrite has an average grain size of about 10 μm and a porosity of about 0.05% and the temperature at which discontinuous grain growth occurred was 1,380°C. From this polycrystal of ferrite and a single crystal of ferrite having substantially the same composition as the ferrite polycrystal and produced by a high pressure Bridgman process, plates 15×15×5 mm and 15×15×0.5 mm respectively were cut off and each contacting surface of these plates was polished with a tin disc by means of diamond abrasive grains to a roughness Rmax of 0.05 μm. 9N HNO₃ solution was applied onto the polished contacting surfaces and the polycrystal of ferrite plate and the single crystal of ferrite plate were superposed and heated at 1,150°C for 30 minutes under a nitrogen atmosphere and then maintained for 4 hours at a temperature of 1,360°C, which is lower than the above described temperature of 1,380°C at which discontinuous grain growth of the polycrystal of ferrite occurs, to cause a solid phase reaction. Thus, the originally superposed polycrystal of ferrite was entirely formed into a single crystal to obtain an integral single crystal of ferrite having a thickness of 5.5 mm.

A polycrystal of ferrite produced by using as iron oxide hematite ($\alpha$-Fe₂0₃) having hysteresis of spinel structure, which had been prepared by heating magnetite under an oxidizing atmosphere under the same conditions as described above, and a polycrystal of ferrite produced by using hematite having no hysteresis of spinel structure, which had been prepared by roasting iron oxalate in air under the same conditions as described above, were subjected to a comparative test. In the former polycrystal of ferrite, the average grain size was about 10 μm and the porosity was about 0.1%, and as the result of a heating test the temperature at which discontinuous grain growth occurred was determined to be 1,380°C. When this polycrystal of ferrite and a single crystal of ferrite were superposed in the same manner as described above and heated at 1,360°C for 4 hours, the originally superposed polycrystal of ferrite was entirely formed into a single crystal. On the other hand, the latter polycrystal of ferrite having no hysteresis of spinel structure had an average grain size of about 25 μm and a porosity of about 0.2%, and in a heating test the crystal grain grew continuously and no discontinuous grain growth was observed. When this polycrystal of ferrite and a single crystal of ferrite were superposed in the same manner as described above and heated at 1,400°C for 4 hours, the single crystal of ferrite grew only about 0.1 mm and no single crystal of ferrite of commercially usable size was obtained.

Example 3

Iron oxide which is maghemite ($\gamma$-Fe₂0₃) and containing 0.005% of SiO₂, 0.003% of TiO₂, 0.0050% of CaO and 0.005% of Na₂0 as impurities, which had been prepared by feeding air to a suspension of ferrous hydroxide prepared by adding ammonia to an aqueous solution of ferrous sulfate while maintaining the pH value at about 4 and the temperature at 60°C to prepare geothite ($\alpha$-FeOOH), drying the geothite and heat-

ing the dried geohite at about 350°C in a hydrogen atmosphere, manganese oxide and zinc oxide, each having a purity of 99.9%, were compounded to obtain a composition comprising 35 mol% of MnO, 11 mol% of ZnO and 54 mol% of Fe₂0₃. The resulting mixture was calcined, milled and then shaped and heated at 1,320°C for 4 hours under equilibrium oxygen partial pressure to obtain a manganese zinc ferrite polycrystal.

This polycrystal of ferrite has an average grain size of about 12 μm and a porosity of 0.1% and the temperature at which discontinuous grain growth occurred was 1,400°C. From this polycrystal of ferrite and a single crystal of ferrite having substantially the same composition as the ferrite polycrystal and produced by a high pressure Bridgman process, plates 15×15×5 mm and 15×15×0.5 mm respectively were cut off and each contacting surface of these plates was polished with a tin disc by means of diamond abrasive grains to a roughness Rmax of 0.05 μm. 6N HNO₃ solution was applied onto the polished contacting surfaces and the polycrystal of ferrite plate and the single crystal of ferrite plate were superposed and heated at 1,150°C for 30 minutes under a nitrogen atmosphere and then maintained in a nitrogen atmosphere having an oxygen concentration of 5% for 4 hours at a temperature of 1,370°C, which is lower than the above described temperature of 1,400°C at which discontinuous grain growth of the polycrystal of ferrite occurs, to cause a solid phase reaction. Thus, the orginally superposed polycrystal of ferrite was entirely formed into a single crystal to obtain an integral single crystal of ferrite having a thickness of 5.5 mm.

For comparison, a test was made by using a polycrystal of ferrite which had been prepared under the same conditions as described above by using iron oxide having no hysteresis of spinel structure obtained by roasting geothite ($\alpha$-FeOOH) in air. This polycrystal of ferrite had an average grain size of about 22 μm and a porosity of about 0.1% and the crystal grain grew continuously and discontinuous grain growth was not observed. When this polycrystal of ferrite and a single crystal of ferrite were superposed in the same manner as described above and heated at 1,400°C for 4 hours, the single crystal of ferrite grew only about 0.1 mm and a single crystal of ferrite of commercially usable size was not obtained.

Example 4

Iron oxide obtained by mixing maghemite ($\gamma$-Fe₂0₃) having a spinel structure, which was used in Example 3, with 35% by weight calculated as Fe₂0₃ of hematite having no hysteresis of spinel structure, which has been prepared by roasting ferrous sulfate in air, manganese oxide and zinc oxide, each having a purity of 99.9%, were compounded to obtain a composition comprising 29.5 mol% of MnO, 16.5 mol% of ZnO and 54 mol% of Fe₂0₃. The resulting mixture was calcined, milled and then shaped and heated at 1,320°C for 4 hours under equilibrium oxygen partial pressure to obtain a manganese zinc ferrite polycrystal.

This polycrystal of ferrite had an average grain size of 15 µm and a porosity of 0.1% and the temperature at which discontinuous crystal grain growth occurred was 1,420°C. This polycrystal of ferrite and a single crystal of ferrite were superposed in the same manner as described in Example 3 and heated for 4 hours at 1,410°C, which is lower than the temperature at which discontinuous grain growth of the polycrystal of ferrite occurs, to cause a solid phase reaction. As a result, the orginally superposed polycrystal of ferrite was entirely formed into a single crystal.

For comparison, a test was made by using a polycrystal of ferrite which had been prepared by using iron oxide obtained by mixing maghemite with 45% by weight calculated as $Fe_2O_3$ of hematite obtained by roasting ferrous sulfate in air as the starting material of iron oxide. This polycrystal of ferrite had an average grain size of about 17 µm and a porosity of about 0.2% and a heating test showed continuous grain growth, and discontinuous grain growth was not observed. When this polycrystal of ferrite and a single crystal of ferrite were superposed in the same manner as described above and heated at 1,420°C for 4 hours, the single crystal of ferrite grew only about 0.1 mm.

In order to examine the effect of the present invention, magnetic heads for VTR images were manufactured from the single crystals of ferrite produced in Examples 1, 2, 3 and 4 and the ferrite of composite structure prepared by forming a part of a polycrystal of ferrite into a single crystal in Example 1, and the properties of these magnetic heads were compared with those of a magnetic head manufactured by using a single crystal of ferrite prepared by a conventional Bridgman process. The results were as follows. As regards output, the former was substantially equal to the latter, but as regards sliding noise (S/N ratio), the former was superior by 1—3 dB to the latter, and in particular the magnetic head using the ferrite of composite structure wherein a part of the polycrystal of ferrite was formed into a single crystal was superior by 3 dB to that of the latter.

As mentioned above, the production of a single crystal of ferrite by the method of the present invention is characterized in that the polycrystal of ferrite utilized is obtained by using iron oxide containing iron oxide of spinel structure, iron oxide having hysteresis of spinel structure or a mixture thereof in an amount of more than 60% by weight calculated as $Fe_2O_3$, the polycrystal of ferrite is contacted with a single crystal of ferrite having substantially the same composition as the ferrite polycrystal and the contacted ferrites are heated at a temperature lower than the temperature at which discontinuous grain growth of the polycrystal of ferrite occurs, to cause a solid phase reaction, whereby the single crystal of ferrite is grown toward the polycrystal of ferrite. This method can produce a single crystal of ferrite at a temperature lower than that of the conventional Bridgman process wherein the single crystal of ferrite is produced from the liquid phase, so that there is no problem of variation of composition due to vaporization of zinc oxide and the single crystal of ferrite can be very simply produced by a conventional firing method without requiring large size complicated and expensive apparatus.

The present invention can be applied to both soft ferrite and hard ferrite irrespective of the composition of both the ferrites, and when iron oxide of spinel structure and/or iron oxide having hysteresis of spinel structure is used as the starting material for producing the polycrystal of ferrite in an amount of at least 60% by weight calculated as $Fe_2O_3$, a polycrystal of ferrite exhibiting discontinuous grain growth can be obtained and when this polycrystal of ferrite is contacted with a single crystal seed of ferrite and these ferrites are heated at a temperature lower than the temperature T°C at which discontinuous grain growth occurs, a single crystal of ferrite is formed and, as mentioned above, if the composition of the single crystal of ferrite to which the present invention is applied is determined, the above described temperature T°C is particularly defined and the present invention can be very broadly applied.

According to the present invention, the polycrystal of ferrite contacted with the single crystal seed of ferrite can be formed entirely into a single crystal of ferrite completely integrated with the single crystal seed of ferrite, and also by properly selecting the heating temperature and time a ferrite of composite structure wherein only a part of the polycrystal of ferrite is formed into a single crystal and which is most suitable for a core material of a magnetic head for VTR image can be simply produced. The present invention thus provides a method for commercially producing a single crystal of ferrite at a low cost and is particularly valuable for production of ferrite cores for magnetic heads.

**Claims**

1. A method of producing a single crystal of ferrite wherein a polycrystal of ferrite and a single crystal of ferrite are heated in contact with each other to grow the single crystal of ferrite toward the polycrystal of ferrite, characterized in that the polycrystal of ferrite is produced by using iron oxide containing iron oxide of spinel structure and/or iron oxide having hysteresis of spinel structure in an amount of not less than 60% by weight calculated as $Fe_2O_3$, and in that the said heating is effected at a temperature lower than the temperature at which discontinuous grain growth of the polycrystal of ferrite is caused.

2. A method as claimed in Claim 1, characterized in that the iron oxide contains not less than 80% by weight calculated as $Fe_2O_3$ of iron oxide of spinel structure and/or iron oxide having hysteresis of spinel structure.

3. A method as claimed in Claim 1 or 2, characterized in that impurities in the iron oxides comprise less than 0.02% by weight of SiO$_2$ and CaO respectively.

## Patentansprüche

1. Verfahren zur Herstellung eines Ferrit-Einkristalls, bei dem eim Ferrit-Polykristall und ein Ferrit-Einkristall in gengenseitegem Kontakt erhitzt werden, um den Ferrit-Einkristall in Richtung auf den Ferrit-Polykristall wachsen zu lassen, dadurch gekennzeichnet, daß der Ferrit-Polykristall unter Verwendung von Eisenoxid hergestellt wird, das Eisenoxid von Spinellstruktur und/ oder die Hysterese von Spinellstruktur aufweisendem Eisenoxid in einer Menge von nicht weniger als 60 Gew.-% bei Berechnung als Fe$_2$0$_3$ enthält, und daß das Erhitzen bei einer Temperatur ausgeführt wird, die niedriger als die Temperatur ist, bei der ein diskontinuierliches Kornwachstum des Ferrit-Polykristalls hervorgerufen wird.

2. Verfahren nach Anspruch 1, dadurch gekennzeichnet, daß das Eisenoxid nicht weniger als 80 Gew.-% bei Berechnung als Fe$_2$0$_3$ von Eisenoxid mit Spinellstruktur und/oder die Hysterese von Spinellstruktur aufweisendem Eisenoxid enthält.

3. Verfahren nach Anspruch 1 oder 2, dadurch gekennzeichnet, daß Verunreinigungen in den Eisenoxiden weniger als 0,02 Gew.-% SiO$_2$ bzw. CaO aufweisen.

## Revendications

1. Méthode de fabrication d'un monocristal de ferrite où un polycristal de ferrite et un monocristal de ferrite sont chauffés en contact l'un avec l'autre pour faire croître le monocristal de ferrite vers le polycristal de ferrite, caractérisée en ce que le polycristal de ferrite est produit en utilisant de l'oxyde de fer contenant de l'oxyde de fer de structure de spinelle et/ou de l'oxyde de fer ayant une hystérésis de structure de spinelle en une quantité de pas moins de 60% en poids en calculant sous la forme de Fe$_2$0$_3$ et en ce que ledit chauffage est effectué à une température plus faible que le température à laquelle se produit une croissance discontinue de grain du polycristal de ferrite.

2. Méthode de la revendication 1 caractérisée en ce que l'oxyde de fer ne contient pas moins de 80% en poids, en calculant sous forme de Fe$_2$0$_3$ d'oxyde de fer de structure de spinelle et/ ou d'oxyde de fer ayant une hystérésis de structure de spinelle.

3. Méthode de la revendication 1 ou 2 caractérisée en ce que des impuretés dans les oxydes de fer comprennent moins de 0,02% en poids de SiO$_2$ et CaO, respectivement.

**0 039 593**

**FIG. 1**

Average Grain Size (μm)

*A*

*B*

*T°*

Firing Temperature (°C)

**FIG. 2**

Average Grain Size (μm)

*C*

*D*

Firing Maintaining Time (hr)

1